# EUROPÄISCHE PATENTSCHRIFT

(11) **EP 0 344 569 B1**
(45) Veröffentlichungstag und Bekanntmachung des Hinweises auf die Patenterteilung: **02.08.1995**
(21) Anmeldenummer: 89109202.5
(22) Anmeldetag: 22.05.1989
(51) Int. Cl.: H01H 9/02, H03K 17/945

(54) **Elektronisches Schaltgerät, insbesondere Näherungsschalter**
Electronic switching device, particularly proximity switch
Appareil de commutation électronique notament interrupteur de proximité

(30) Priorität: 31.05.1988 DE 3818499
(43) Veröffentlichungstag der Anmeldung: 06.12.1989
(73) Patentinhaber: i f m electronic gmbh, D-45127 Essen (DE)
(72) Erfinder: Mehnert, Wolfgang, D-8990 Lindau-Reutin (DE)
(74) Vertreter: Gesthuysen, Hans Dieter, Dipl.-Ing.

(56) Entgegenhaltungen:
- DE-A- 3 203 944
- DE-C- 3 029 595
- DE-C- 3 117 386

## Beschreibung

Die Erfindung betrifft ein elektronisches Schaltgerät, mit einer an einer Stirnseite geschlossenen Innenhülse, einem die Innenhülse an der offenen Stirnseite verschließenden Stopfen, einer die Innenhülse umgebenden Außenhülse und einem innerhalb der Innenhülse angeordneten optischen Schaltzustandsanzeiger insbesondere einer Leuchtdiode, wobei die Innenhülse aus elektrisch isolierendem, für Wasser, Staub und andere Medien in der Umgebungsatmosphäre undurchlässigen Kunststoff besteht sowie hermetisch dicht und durchschlagsfest ausgeführt ist, der Stopfen als Kabeldurchführung ausgebildet ist, aus elektrisch isolierendem, für Wasser, Staub und andere Medien in der Umgebungsatmosphäre undurchlässigen Kunststoff besteht und hermetisch dicht ausgeführt ist und die Außenhülse aus Metall besteht.

Elektronische Schaltgeräte der zuvor erläuterten Art sind in einer Vielzahl von Ausführungsformen bekannt, insbesondere als induktive, kapazitive und optoelektronische Näherungsschalter. Mit Hilfe der aus Metall bestehenden und mit einem Außengewinde versehenen Außenhülse können solche Schaltgeräte in maßlich vorgegebene Gewindefassungen am Einsatzort eingeschraubt werden. Der für die Schaltungsanordnung zur Verfügung stehende lichte Durchmesser wird durch den fest vorgegebenen Außendurchmesser und durch die Wandstärken der Innenhülse und der Außenhülse bestimmt. Bei einem kleinen Außendurchmesser, nämlich 18 mm und weniger, muß man für die Innenhülse sehr geringe Wandstärken, nämlich Wandstärken von weniger als 0,5 mm, vorzugsweise von ca. 0,4 mm realisieren. Das wiederum kollidiert mit höheren Anforderungen an die Dichtigkeit und Durchschlagsfestigkeit, wie sie beispielsweise für die VDE-Schutzart IP 67 gestellt sind. Diese Anforderungen erfordern nach derzeitiger Meinung der Fachwelt regelmäßig den Verguß der Schaltungsanordnung mit Gießharz.

Ein besonderes Problem ergibt sich dann, wenn im Inneren der Innenhülse ein optischer Schaltzustandsanzeiger vorgesehen ist, der von außerhalb der Außenhülse erkennbar sein soll. Eine Vielzahl von Ansätzen sind bislang gemacht worden, um unter diesen Voraussetzungen die z. B. für die VDE-Schutzart IP 67 gestellten Anforderungen an Dichtigkeit und Durchschlagsfestigkeit zu erreichen (vgl. die DE-PS 30 29 595 einschließlich des dort referierten Standes der Technik). Soweit diese bekannten Lösungsansätze grundsätzlich sinnvoll sind, sind sie jedenfalls bei den vorliegend geforderten geringen Wandstärken nicht realisierbar.

Das aus der Praxis bekannte elektronische Schaltgerät mit einstückig ausgeführter, nämlich gespritzter Innenhülse hat bei Wandstärken in der hier relevanten Größenordnung aus spritztechnischen Gründen eine maximale Länge von ca. 40 mm. Dies reicht für viele Anwendungsfälle nicht aus. Im übrigen verbleibt das zuvor erläuterte Sonderproblem in Verbindung mit einem optischen Schaltzustandsanzeiger, insbesondere einer Leuchtdiode.

Der Erfindung liegt nun die Aufgabe zugrunde, das bekannte elektronische Schaltgerät so zu verbessern, daß es auch bei der geforderten geringen Wandstärke der Innenhülse hohe Anforderungen an Dichtigkeit und Durchschlagsfestigkeit erfüllt, beispielsweise für die VDE-Schutzart IP 67, wobei der optische Schaltzustandsanzeiger weiter von außen erkennbar sein soll.

Das erfindungsgemäße elektronische Schaltgerät, bei dem die zuvor aufgezeigte Aufgabe gelöst ist, ist dadurch gekennzeichnet, daß die Innenhülse zweiteilig ausgeführt ist, nämlich aus einem ersten, dem Stopfen benachbarten, beidseitig offenen Hülsenteil und einem zweiten, einseitig geschlossenen Hülsenteil besteht, das erste Hülsenteil aus durchsichtigem oder durchscheinendem Kunststoff und das zweite Hülsenteil aus zu dem ersten Hülsenteil verbindungstechnisch passendem, abdichtungstechnisch und isolationstechnisch gleichen oder gleichwertigen, nicht durchsichtigen oder durchscheinenden, insbesondere eingefärbten Kunststoff besteht, das erste Hülsenteil und das zweite Hülsenteil miteinander dauerhaft hermetisch dicht und durchschlagsfest verbunden sind und die Außenhülse im Bereich des ersten Hülsenteils eine Beobachtungsöffnung für den optischen Schaltzustandsanzeiger aufweist. Dadurch läßt sich die Innenhülse, wie auch die Außenhülse aus Metall, in praktisch jeder beliebigen Länge auch bei den geforderten geringen Wandstärken herstellen. Insbesondere kann das erste Hülsenteil als Extrusionsteil und das zweite Hülsenteil als Spritzteil ausgeführt werden. Für das erste Hülsenteil und/oder das zweite Hülsenteil und/oder den Stopfen kann als Werkstoff vorzugsweise Polysulfon verwendet werden.

Bei einer besonders bevorzugten Ausführungsform des erfindungsgemäßen Schaltgerätes sind das erste Hülsenteil und das zweite Hülsenteil durch Ultraschall-Kunststoffschweißung miteinander verbunden. Entsprechende Kunststoffe vorausgesetzt, führt die Ultraschall-Kunststoffschweißung zu einem derart perfekten, dauerhaften Verbund der beiden Hülsenteile, daß diese abdichtungstechnisch und isolationstechnisch wie eine durchgehende Innenhülse wirken, also an der Verbindungsstelle der beiden Hülsenteile keine Schwachstelle in abdichtungstechnischer oder in isolationstechnischer Hinsicht entsteht.

Es gibt nun noch eine Vielzahl von Möglichkeiten, die Lehre der Erfindung auszugestalten und weiterzubilden. Dazu darf zunächst auf die dem Patentanspruch 1 nachgeordneten Patentansprüche verwiesen werden. Im übrigen wird verwiesen auf die nachfolgende, anhand der Zeichnung gegebenen Erläuterung von zwei bevorzugten Ausführungsbeispielen erfindungsgemäßer elektronischer Schaltgeräte. In der Zeichnung zeigt
- Fig. 1: im Schnitt ein erstes Ausführungsbeispiel eines erfindungsgemäßen elektronischen Schaltgerätes und
- Fig. 2: ebenfalls im Schnitt ein zweites Ausführungsbeispiel eines erfindungsgemäßen elektronischen Schaltgerätes.

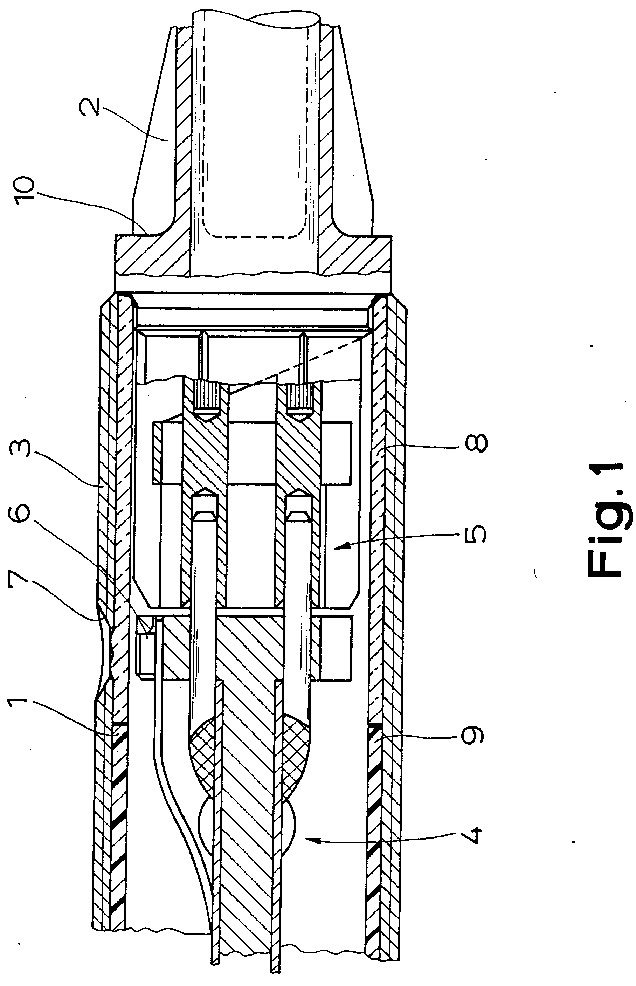

Das in Fig. 1 im Schnitt schematisch dargestellte elektronische Schaltgerät in Form eines Näherungsschalters weist zunächst eine an einer, in Fig. 1 nicht dargestellten Stirnseite geschlossene Innenhülse 1, einen die Innenhülse 1 an der offenen Stirnseite verschließenden Stopfen 2 und eine die Innenhülse 1 umgebende Außenhülse 3 auf. Dabei gilt im einzelnen, daß die Innenhülse 1 aus elektrisch isolierendem, für Wasser, Staub und andere Medien in der Umgebungsatmosphäre undurchlässigen Kunststoff besteht sowie hermetisch dicht und durchschlagsfest ausgeführt ist, der Stopfen 2 als Kabeldurchführung ausgebildet ist, aus elektrisch isolierendem, für Wasser, Staub und andere Medien in der Umgebungsatmosphäre undurchlässigen Kunststoff besteht und hermetisch dicht ausgeführt ist und die Außenhülse 3 aus Metall besteht. Im Inneren der Innenhülse 1 befindet sich eine übliche Schaltungsanordnung 4, hier in üblicher Weise auf einer Schaltungsplatine angedeutet, mit einer entsprechenden elektrischen Anschlußeinrichtung 5. Im hier dargestellten und insoweit bevorzugten Ausführungsbeispiel ist Teil der Schaltungsanordnung 4 ein optischer Schaltzustandsanzeiger 6 vorzugsweise eine Leuchtdiode, die z. B. dann Licht emittiert, wenn das Schaltgerät durchgeschaltet hat, oder die Farbe wechselt, wenn sich der Schaltzustand des Schaltgerätes ändert. Der Schaltzustandsanzeiger 6 befindet sich unmittelbar an der Innenwandung der Innenhülse 1 und ist von außerhalb der Außenhülse 3 erkennbar, nämlich im hier dargestellten und insoweit bevorzugten Ausführungsbeispiel durch eine Beobachtungsöffnung 7 in der Außenhülse 3.

Wesentlich ist nun, daß die Innenhülse 1 zweiteilig ausgeführt ist, nämlich aus einem ersten, dem Stopfen 2 benachbarten, beidseitig offenen Hülsenteil 8 und einem zweiten, einseitig geschlossenen Hülsenteil 9 besteht, das erste Hülsenteil 8 aus durchsichtigem oder durchscheinendem Kunststoff und das zweite Hülsenteil 9 aus zu dem ersten Hülsenteil 8 verbindungstechnisch passendem, abdichtungstechnisch und isolationstechnisch gleichen oder gleichwertigen, nicht durchsichtigen oder durchscheinenden, insbesondere eingefärbten Kunststoff besteht.

In den dargestellten Ausführungsbeispielen ist das erste Hülsenteil 8 als Extrusionsteil und das zweite Hülsenteil 9 als Spritzteil ausgeführt. Die Ausführung des ersten Hülsenteils 8 als Extrusionsteil hat den Vorteil, daß dieses erste Hülsenteil 8 mit praktisch beliebiger Länge bei sehr geringer Wandstärke, beispielsweise bei einer Wandstärke von ca. 0,4 mm hergestellt werden kann.

Von besonderer Bedeutung ist eine Lehre der Erfindung, die in der Zeichnung nur andeutungsweise zu erkennen ist. Diese Lehre geht nämlich dahin, das erste Hülsenteil 8 und das zweite Hülsenteil 9 durch Ultraschall-Kunststoffschweißung miteinander zu verbinden. Diese Verbindungstechnik ist deshalb für den vorliegenden Anwendungsfall besonders geeignet, weil sich ein inniger Stoffverbund der beiden Hülsenteile 8 und 9 ergibt, der die zunächst eigenständigen Hülsenteile 8 und 9 der Innenhülse 1 abdichtungstechnisch und isolationstechnisch wie eine einteilige Innenhülse 1 erscheinen läßt. Dadurch läßt sich die VDE-Schutzart IP 67 mit einer Durchschlagsfestigkeit von 5 kV trotz der geforderten geringen Wandstärke der Innenhülse 1 realisieren, ohne daß die Schaltungsanordnung 4 im Inneren der Innenhülse 1 vergossen werden müßte.

Für die Innenhülse 1 hat sich als Werkstoff Polysulfon oder ein ähnlicher Kunststoff als besonders zweckmäßig erwiesen, insbesondere auch unter Berücksichtigung der vorzugsweise anzuwendenden Ultraschall-Kunststoffschweissung. Polysulfon ist im Handel auch unter den Namen Polyethersulfon, Polyarylsulfon oder Polyphenylensulfon bekannt.

Die zuvor erläuterte, für die Innenhülse 1 zu bevorzugende Werkstoffauswahl gilt in ähnlicher Weise auch für den Stopfen 2 des erfindungsgemäßen elektronischen Schaltgerätes. Der Stopfen 2 eignet sich im übrigen auch zur Einleitung der für die Ultraschall-Kunststoffschweißung erforderlichen Energie in den Stopfen 2 und in die Innenhülse 1. Dazu weist der in Fig. 1 erkennbare Stopfen 2 außen Anlageflächen 10 für eine nicht dargestellte Ultraschall-Schwingungseinrichtung auf.

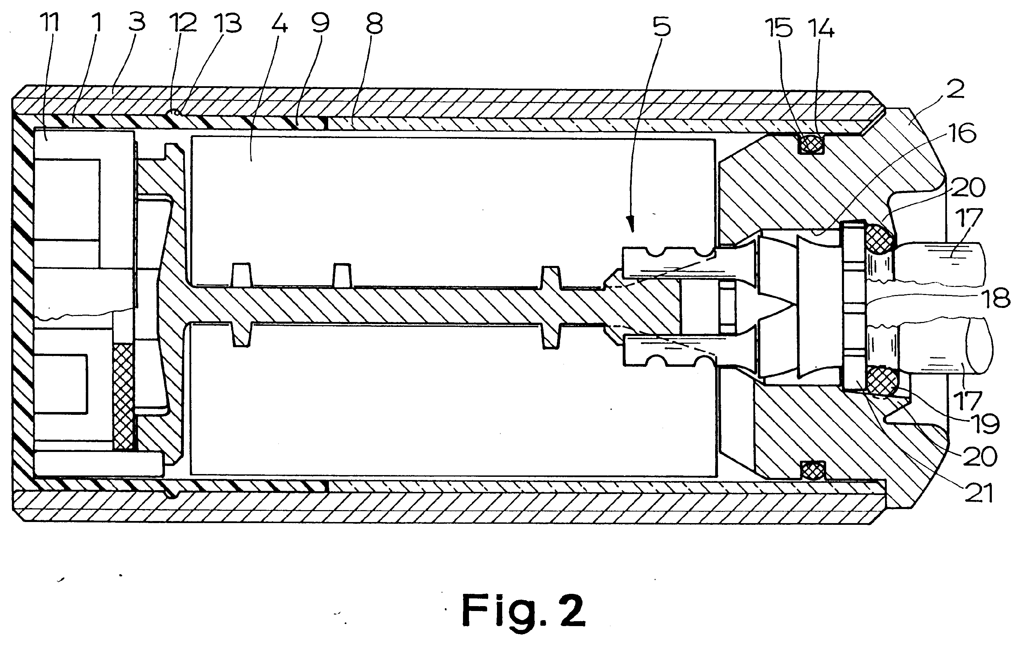

Das in Fig. 2 dargestellte, weiter bevorzugte Ausführungsbeispiel eines erfindungsgemäßen Schaltgerätes zeigt zunächst eine Vielzahl von Übereinstimmungen mit dem in Fig. 1 dargestellten Ausführungsbeispiel. Erkennbar ist hier jedoch das geschlossene Ende der Innenhülse 1 mit dahinter angeordneter Spule 11 des Näherungsschalters; es handelt sich hier also um einen induktiven Näherungsschalter. Erkennbar ist an der Innenhülse 1 auch eine umlaufende Ringsicke 12, die in Verbindung mit einer entsprechenden Ringnut 13 auf der Innenseite der metallischen Außenhülse 3 die Relativlage von Innenhülse 1 und Außenhülse 3 definiert.

Abweichend vom Ausführungsbeispiel nach Fig. 1 ist bei dem Ausführungsbeispiel nach Fig. 2 der Stopfen 2 konstruiert. Hier gilt zunächst, daß der Stopfen 2 über einen auf der Außenseite in einer Aufnahmenut 14 angeordneten 0-Ring 15 gegenüber der Innenhülse 1 abgestützt und abgedichtet ist. Hier besteht also die Verbindung des Stopfens 2 zur Innenhülse 1 nicht dauerhaft durch Ultraschall-Kunststoffschweißung, sondern durch einen Preßsitz mit Hilfe des 0-Ringes 15.

Im übrigen gilt für das Ausführungsbeispiel nach Fig. 2, daß der Stopfen 2 eine mittige Durchführung 16 für ein Kabel 17 und in der Durchführung 16 einen umlaufenden Anlageflansch 18 für einen das Kabel 17 umgebenden O-Ring 19 aufweist, am Stopfen 2 auf der Außenseite des 0-Rings 19 ein Ringvorsprung 20 ausgebildet ist und bei eingestecktem Kabel 17 der Ringvorsprung 20 durch bleibende, insbesondere unter hoher Temperatur ablaufende Verformung des Kunststoffs an das Kabel 17 herangebogen und dadurch der 0-Ring 19 hermetisch abdichtend an das Kabel 17 herangedrückt ist. Dabei ist im übrigen der Anlageflansch 18 an einem in dem Stopfen 2 eingesetzten Stützring 21 ausgebildet.

## Patentansprüche

1. Elektronisches Schaltgerät, mit einer an einer Stirnseite geschlossenen Innenhülse (1), einem die Innenhülse (1) an der offenen Stirnseite verschließenden Stopfen (2) einer die Innenhülse (1) umgebenden Außenhülse (3) und einem innerhalb der Innenhülse (1) angeordnetem optischen Schaltzustandsanzeiger (6), insbesondere einer Leichtdiode, wobei die Innenhülse (1) aus elektrisch isolierendem, für Wasser, Staub und andere Medien in der Umgebungsatmosphäre undurchlässigen Kunststoff besteht sowie hermetisch dicht und durchschlagsfest ausgeführt ist, der Stopfen (2) als Kabeldurchführung ausgebildet ist, aus elektrisch isolierendem, für Wasser, Staub und andere Medien in der Umgebungsatmosphäre undurchlässigen Kunststoff besteht und hermetisch dicht ausgeführt ist und die Außenhülse (3) aus Metall besteht, **dadurch gekennzeichnet,** daß die Innenhülse (1) zweiteilig ausgeführt ist, nämlich aus einem ersten, dem Stopfen (2) benachbarten, beidseitig offenen Hülsenteil (8) und einem zweiten, einseitig geschlossenen Hülsenteil (9) besteht, das erste Hülsenteil (8) aus durchsichtigem oder durchscheinendem Kunststoff und das zweite Hülsenteil (9) aus zu dem ersten Hülsenteil (8) verbindungstechnisch passendem, abdichtungstechnisch und isolationstechnisch gleichen oder gleichwertigen, nicht durchsichtigen oder durchscheinenden, insbesondere eingefärbten Kunststoff besteht, das erste Hülsenteil (8) und das zweite Hülsenteil (9) miteinander dauerhaft hermetisch dicht und durchschlagfest verbunden sind und die Außenhülse (3) im Bereich des ersten Hülsenteils (8) eine Beobachtungsöffnung (7) für den optischen Schaltzustandsanzeiger (6) aufweist.

2. Elektronisches Schaltgerät nach Anspruch 1, dadurch gekennzeichnet, daß das erste Hülsenteil (8) als Extrusionsteil und das zweite Hülsenteil (9) als Spritzteil ausgeführt ist.

3. Elektronisches Schaltgerät nach Anspruch 1 oder 2, dadurch gekennzeichnet, daß das erste Hülsenteil (8) und/oder das zweite Hülsenteil (9) und/oder der Stopfen (2) aus Polysulfon besteht.

4. Elektronisches Schaltgerät nach einem der Ansprüche 1 bis 3, dadurch gekennzeichnet, daß das erste Hülsenteil (8) und das zweite Hülsenteil (9) durch Ultraschall-Kunststoffschweißung miteinander verbunden sind.

5. Elektronisches Schaltgerät nach einem der Ansprüche 1 bis 4, dadurch gekennzeichnet, daß der Stopfen (2) mit dem ersten Hülsenteil (8) durch Ultraschall-Kunststoffschweißung verbunden ist.

6. Elektronisches Schaltgerät nach Anspruch 4 oder 5, dadurch gekennzeichnet, daß außen am Stopfen (2) Anlageflächen (10) für eine Ultraschall-Schwingungseinrichtung ausgebildet sind.

7. Elektronisches Schaltgerät nach einem der Ansprüche 1 bis 4 oder nach Anspruch 6, dadurch gekennzeichnet, daß der Stopfen (2) über einen auf der Außenseite in einer Aufnahmenut (14) angeordneten 0-Ring (15) gegenüber dem ersten Gehäuseteil (8) abgestützt und abgedichtet ist.

8. Elektronisches Schaltgerät nach einem der Ansprüche 1 bis 7, dadurch gekennzeichnet, daß der Stopfen (2) eine mittige Durchführung (16) für ein Kabel (17) und in der Durchführung (16) einen umlaufenden Anlageflansch (18) für einen das Kabel (17) umgebenden 0-Ring (19) aufweist, am Stopfen (2) auf der Außenseite des 0-Ringes (19) ein Ringvorsprung (20) ausgebildet ist und bei eingestecktem Kabel (17) der Ringvorsprung (20) durch bleibende, insbesondere unter hoher Temperatur ablaufende Verformung des Kunststoffs an das Kabel (17) herangebogen und dadurch der 0-Ring (19) hermetisch abdichtend an das Kabel (17) herangedrückt ist.

9. Elektronisches Schaltgerät nach Anspruch 8, dadurch gekennzeichnet, daß der Anlageflansch (18) an einem in dem Stopfen (2) eingesetzten Stützring (21) ausgebildet ist.

## Claims

1. An electronic switching device having an inner sleeve (1) closed at one end, a plug (2) closing the inner sleeve (1) at its open end, an outer sleeve (3) surrounding the inner sleeve (1) and an optical switching state indicator (6), particularly a light-emitting diode, disposed inside the inner sleeve (1), wherein the inner sleeve (1) consists of an electrically insulating plastics which is impermeable to water, dust and other media in the ambient atmosphere and is of hermetically sealed and dielectric breakdown-resistant construction, the plug (2) is constructed as a cable lead-through and consists of an electrically insulating plastics which is impermeable to water, dust and other media in the ambient atmosphere and is of hermetically sealed construction, and the outer sleeve (3) consists of metal, characterised in that the inner sleeve (1) is constructed in two parts, namely from a first sleeve part (8) adjacent to the plug (2) and open at both ends and a second sleeve part (9) closed at one end, the first sleeve part (8) consists of transparent or translucent plastics and the second sleeve part (9) consists of plastic which is matched to the first sleeve part (8) as regards joining technology, is the same or equivalent as regards its sealing and insulation properties, is not transparent or translucent, and in particular is coloured, the first sleeve part (8) and the second sleeve part (9) are joined to each other in a manner which provides a permanent hermetic seal and dielectric strength, and the outer sleeve (3) has an observation aperture (7) in the region of the first sleeve part (8) for the optical switching state indicator (6).

2. An electronic switching device according to claim 1, characterised in that the first sleeve part (8) is constructed as an extruded part and the second sleeve part (9) is constructed as an injection moulded part.

3. An electronic switching device according to claim 1 or 2, characterised in that the first sleeve part (8) and/or the second sleeve part (9) and/or the plug (2) consist of polysulphone.

4. An electronic switching device according to any one of claims 1 to 3, characterised in that the first sleeve part (8) and the second sleeve part (9) are joined to each other by ultrasonic plastics welding.

5. An electronic switching device according to any one of claims 1 to 4, characterised in that the plug (2) is joined to the first sleeve part (8) by ultrasonic plastics welding.

6. An electronic switching device according to claim 4 or 5, characterised in that support faces (10) for an ultrasonic vibration device are constructed on the outside of the plug (2).

7. An electronic switching device according to any one of claims 1 to 4 or according to claim 6, characterised in that the plug (2) is supported and sealed in relation to the first sleeve part (8) via an O-ring (15) disposed in a seating groove (14) on the outside.

8. An electronic switching device according to any one of claims 1 to 7, characterised in that the plug (2) has a central lead-through (16) for a cable (17) and has a surrounding support flange (18) in the lead-through (16) for an O-ring (19) surrounding the cable (17), an annular projection (20) is constructed on the plug (2) on the outside of the O-ring (19) and when the cable (17) is inserted the annular projection (20) is bent on to the cable (17) by permanent deformation of the plastic, carried out in particular at high temperature, and the O-ring (19) is thereby pressed hermetically sealed on to the cable (17).

9. An electronic switching device according to claim 8, characterised in that the support flange (18) is formed on a support ring (21) inserted in the plug (2).

## Revendications

1. Commutateur électronique, comportant une douille interne (1) fermée sur une face avant, un obturateur (2) fermant la douille interne (1) sur la face avant ouverte, une douille externe (3) entourant la douille interne (1) et un indicateur optique d'état de commutation (6), en particulier une LED, agencé à l'intérieur de la douille interne (1), la douille interne (1) étant constituée d'une matière plastique isolante de l'électricité, imperméable à l'eau, à la poussière et à d'autres agents de l'atmosphère ambiante, hermétiquement étanche et résistant au claquage, l'obturateur (2), qui se présente sous une forme câblée, étant constitué d'une matière plastique isolant de l'électricité, imperméable à l'eau, à la poussière et à d'autres agents de l'atmosphère ambiante, hermétiquement étanche et résistant au claquage, et la douille externe (3) étant constituée de métal, caractérisé en ce que la douille interne (1) est divisée en deux parties, à savoir qu'elle est constituée d'une premier partie de douille (8) voisine de l'obturateur (2) et ouverte des deux côtés et d'une deuxième partie de douille (9) fermée d'un côté, la première partie de douille (8) est formée d'une matière plastique transparente ou translucide et la deuxième partie de douille (9) est formée d'une matière plastique non transparente ou translucide, en particulier d'une matière plastique colorée, raccordée à la première partie de douille (1), égale ou équivalente à celle-ci en termes d'étanchéité et d'isolation, la première partie de douille (8) et la deuxième partie de douille (9) sont raccordées l'une à l'autre en permanence de manière hermétiquement étanche et avec une résistance au claquage, et la douille externe (3) présente, dans la zone de la première partie de douille (8), une ouverture d'observation (7) pour l'indicateur optique d'état de commutation (6).

2. Commutateur électronique selon la revenedication 1, caractérisé en ce que la première partie de douille (8) peut être réalisée sous la forme d'une pièce extrudée et la deuxième partie de douille (9) sous la forme d'une pièce moulée par injection.

3. Commutateur électronique selon la revendication 1 ou 2, caractérisé en ce que la première partie de douille (8) et/ou la deuxième partie de douille (9) et/ou l'obturateur (2) sont constitués d'une polysulfone.

4. Commutateur électronique selon l'une quelconque des revendications 1 à 3, caractérisé en ce que la première partie de douille (8) et la deuxième partie de douille (9) sont raccordées l'une à l'autre par soudage aux ultrasons.

5. Commutateur électronique selon l'une quelconque des revendications 1 à 4, caractérisé en ce que l'obturateur (2) est raccordé à la première partie de douille (8) par soudage aux ultrasons.

6. Commutateur électronique selon la revendication 4 ou 5, caractérisé en ce que des surfaces d'application (10) sont formées sur l'obturateur (2) à l'extérieur pour un dispositif émetteur d'ultrasons.

7. Commutateur électronique selon l'une quelconque des revendications 1 à 4 ou selon la revendication 6, caractérisé en ce que l'obturateur (2) est appuyé et étanché contre la douille interne (1) via un joint torique (15) agencé sur le côté externe dans une rainure réceptrice (14).

8. Commutateur électronique selon l'une quelconque des revendications 1 à 7, caractérisé en ce que l'obturateur (2) présente une partie d'introduction centrale (16) pour un câble (17) et dans la partie d'introduction (16) une bride d'application périphérique (18) pour un joint torique (19) entourant le câble (17), sur l'obturateur (2), sur la face externe du joint torique (19), est formée une saillie annulaire (20) et, lorsque le câble (17) est enfiché, la saillie annulaire (20) est fléchie sur le câble (17) par la déformation permanente qui se produit en particulier à température élevée et, de ce fait, le joint torique (19) est pressé sur le câble (17) avec une étanchéité hermétique.

9. Commutateur électronique selon la revendication 8, caractérisé en ce que la bride d'application (18) est formée sur une bague d'appui (21) insérée dans l'obturateur (2).
